(19) 

Europäisches
Patentamt
European
Patent Office
Office européen
des brevets

(11) **EP 4 057 363 A1**

(12) # EUROPEAN PATENT APPLICATION
published in accordance with Art. 153(4) EPC

(43) Date of publication:
**14.09.2022 Bulletin 2022/37**

(21) Application number: **20883811.0**

(22) Date of filing: **02.11.2020**

(51) International Patent Classification (IPC):
**H01L 33/42** (2010.01)   **B32B 9/00** (2006.01)

(52) Cooperative Patent Classification (CPC):
**B32B 9/00; H01L 33/42**

(86) International application number:
**PCT/JP2020/041005**

(87) International publication number:
**WO 2021/090790 (14.05.2021 Gazette 2021/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.11.2019 JP 2019203232**

(71) Applicants:
• **Idemitsu Kosan Co., Ltd.
Chiyoda-ku
Tokyo 100-8321 (JP)**
• **National University Corporation Tokai National
Higher Education and Research System
Nagoya-shi, Aichi 464-8601 (JP)**

(72) Inventors:
• **TOMAI, Shigekazu
Sodegaura-shi, Chiba 299-0293 (JP)**

• **UEOKA, Yoshihiro
Sodegaura-shi, Chiba 299-0293 (JP)**
• **KATSUMATA, Satoshi
Sodegaura-shi, Chiba 299-0293 (JP)**
• **KUSHIMOTO, Maki
Nagoya-shi, Aichi 464-8601 (JP)**
• **DEKI, Manato
Nagoya-shi, Aichi 464-8601 (JP)**
• **HONDA, Yoshio
Nagoya-shi, Aichi 464-8601 (JP)**
• **AMANO, Hiroshi
Nagoya-shi, Aichi 464-8601 (JP)**

(74) Representative: **Gille Hrabal
Partnerschaftsgesellschaft mbB
Patentanwälte
Brucknerstraße 20
40593 Düsseldorf (DE)**

(54) **LAMINATE AND SEMICONDUCTOR DEVICE**

(57)    A stacked body comprising a support, a buffer
layer, and an electrode layer in this order, wherein the
buffer layer comprises one or more metals selected from
the group consisting of Ga, Al, In, and Zn, and oxygen,
the electrode layer comprises an oxide of magnesium
and an oxide of zinc, and the electrode layer has a half
width of a diffraction peak observed at $2\theta = 34.8 \pm 0.5$
deg in X-ray diffraction measurement of 0.43 deg or
smaller.

Figure 1

EP 4 057 363 A1

**Description**

Technical Field

The invention relates to a stacked body and a semiconductor device having an electrode layer transmitting ultraviolet rays.

Background Art

Deep ultraviolet light-emitting semiconductor devices using nitride semiconductors such as gallium nitride are attracting attention as deep ultraviolet light sources having a light-weight and a long-lifetime. The deep ultraviolet light source can be applied in various fields such as pasteurization, sensing, and industrial applications. Since mercury lamps, which are conventional deep ultraviolet light sources, have environmental problems of mercury, deep ultraviolet light-emitting semiconductor devices are expected as an alternative art thereof.

Conventionally, for the light-emitting diode of visible light, tin-doped indium oxide (ITO) is widely used as a transparent electrode.

In addition, Patent Document 1 discloses a specific oxide of indium as a material excellent in visible-light transmittance and conductivity.

Further, Patent Document 2 discloses a specific oxide sintered body containing zinc oxide and magnesium as a material used for forming a transparent conductive film which exhibits excellent chemical resistance without significantly impairing visible-light transmittance and conductivity by a vapor deposition method.

Related Art Documents

Patent Documents

[Patent Document 1] JP H8-245220 A
[Patent Document 2] JP 2014-129230 A1

Summary of the Invention

In order for a deep ultraviolet light-emitting semiconductor device to achieve excellent luminous efficiency in the ultraviolet region, an electrode excellent in ultraviolet transmittance and conductivity is required.

However, ITO, which has been used in light-emitting diodes of visible light, is inferior in ultraviolet transmittance, so that it cannot achieve both ultraviolet transmittance and conductivity at the same time. The techniques disclosed in Patent Documents 1 and 2 also have room for improvement in terms of achieving both ultraviolet transmittance and conductivity at the same time.

One of the objects of the invention is to provide a stacked body having an electrode layer excellent in ultraviolet transmittance and conductivity.

One of the objects of the invention is to provide a semiconductor device having excellent luminous efficiency in the ultraviolet region.

According to the invention, the following stacked body and so on are provided.

1. A stacked body comprising a support, a buffer layer, and an electrode layer in this order, wherein

the buffer layer comprises one or more metals selected from the group consisting of Ga, Al, In, and Zn, and oxygen,
the electrode layer comprises an oxide of magnesium and an oxide of zinc, and
the electrode layer has a half width of a diffraction peak observed at $2\theta = 34.8 \pm 0.5$ deg in X-ray diffraction measurement of 0.43 deg or smaller.

2. The stacked body according to 1, wherein a stacked unit comprising the electrode layer and the buffer layer has a conductivity of 0.5 S/cm or larger.

3. The stacked body according to 1 or 2, wherein a molar ratio of Mg to the sum of Mg and Zn [Mg/(Mg+Zn)] in the electrode layer is 0.25 or more 0.75 or less.

4. The stacked body according to any one of 1 to 3, wherein the stacked unit comprising the electrode layer and the buffer layer has a light transmittance at a wavelength of 260 nm of 4% or more.

5. The stacked body according to any one of 1 to 4, wherein the electrode layer has a degree of c-axis orientation of 40% or more.

6. A stacked body according to any one of 1 to 5, wherein the buffer layer comprises an oxide of zinc.

7. The stacked body according to any one of 1 to 6, wherein the buffer layer comprises an oxide of gallium and an oxide of zinc.

8. The stacked body according to any one of 1 to 7, wherein a molar ratio of Ga to the sum of Ga and Zn [Ga/(Ga+Zn)] in the buffer layer is 0.000 or more and 0.2 or less.

9. The stacked body according to any one of 1 to 8, wherein the support comprises an ultraviolet transmitting member.

10. The stacked body according to any of 1 to 8, wherein the support comprises a semiconductor layer.

11. The stack body according to 10, wherein the semiconductor layer comprises a Group III-V nitride semiconductor.

12. The stacked body according to 10 or 11, wherein the semiconductor layer comprisesAlN, GaN, InN, or a mixed crystal thereof.

13. A semiconductor device, comprising the stacked body according to any one of 1 to 12.

According to an aspect of the invention, it is possible to provide a stacked body having an electrode layer excellent in ultraviolet transmittance and conductivity.

According to an aspect of the invention, it is possible to provide a semiconductor device having excellent luminous efficiency in the ultraviolet region.

Brief Description of the Drawings

Figure 1 is a schematic-configuration diagram of a light-emitting diode (LED) according to the first embodiment.
Figure 2 is a schematic-configuration diagram of an LED according to a second embodiment.
Figure 3 is a schematic-configuration diagram of an LED according to a third embodiment
Figure 4 is a schematic cross-sectional view of an LED sample for evaluation fabricated in Examples and Comparative Examples.
Figure 5 is a transmission electron microscope (TEM) image of the electrode layer of an LED fabricated in Example 1.
Figure 6 is an X-ray diffraction pattern of the electrode layer of Example 1.
Figure 7 is a graph showing the relationship between the mobility $\mu$ and the carrier concentration n of the electrode layer of LEDs fabricated in Examples, Comparative Examples, and Reference Examples.
Figure 8 is a TEM image of the electrode layer of an LED fabricated in Comparative Example 1.
Figure 9 is an X-ray diffraction pattern of the electrode layer of an LED fabricated in Comparative Example 1.
Figure 10 is an X-ray diffraction pattern of the electrode layer of an LED fabricated in Comparative Example 3.
Figure 11 is light transmission spectra of the electrode layers of LEDs fabricated in Comparative Example 4 and Reference Examples 1 to 3.

Mode for Carrying out the Invention

[Stacked body]

A stacked body according to an aspect of the invention has a support, a buffer layer, and an electrode layer in this order. The buffer layer contains one or more metals selected from the group consisting of Ga, Al, In, and Zn, and oxygen. The electrode layer contains an oxide of magnesium and an oxide of zinc. The electrode layer has a half-width of a diffraction peak observed at $2\theta = 34.8 \pm 0.5$ deg in X-ray diffraction measurement of 0.43 deg or smaller. The stacked body according to this aspect has an effect of excellent ultraviolet transmittance (e.g., permeability in a region having a wavelength of 400 nm or shorter) and conductivity of the electrode layer.

[Support]

The support is not particularly limited and preferably has one or more selected from the group consisting of an ultraviolet transmitting member and a semiconductor layer.

The ultraviolet transmitting member may contain a material capable of transmitting ultraviolet rays such as, for example, glass, quartz, resin, or the like. From the viewpoint of heat resistance, glass or quartz is suitable.

A semiconductor contained in the semiconductor layer is not particularly limited, and for example, a Group III-V nitride semiconductor is suitable. Examples of such a semiconductor include GaN, InGaN, AlGaN, AllnGaN, AlN, InN, BN, and the like. The semiconductor layer preferably contains AlN, GaN, InN, or a mixed crystal thereof.

The semiconductor layer may be an n-type semiconductor, also may be a p-type semiconductor. As an n-type dopant, Si or the like can be used. As an p-type dopant, Mg or the like can be used. In addition to Si and Mg, known dopants can be used.

The semiconductor layer can be formed, for example, by means of epitaxial growing on a support substrate for forming a semiconductor layer. A material of the support substrate is not particularly limited and examples thereof include, for example, GaN, InGaN, AlGaN, AlN, InN, SiC, Si, sapphire, and the like.

In one embodiment, the semiconductor layer is provided such that it directly contact with the buffer layer. In one embodiment the support may have a semiconductor layer and a support substrate containing a material different from the semiconductor layer. For example, the support may have a semiconductor layer containing GaN on the buffer layer side, and a support substrate containing Si on the opposite side of the buffer layer viewed from the semiconductor layer.

The thickness of the semiconductor layer can be appropriately adjusted depending on the purpose and application (e.g., so as to be able to obtain desired electrical characteristics), and is preferably in the range of 10 nm to 2 mm, for example.

Which is the semiconductor layer, a p-type semiconductor or an n-type semiconductor, is determined by a Hall-effect measurement When a Hall-effect measurement is difficult to perform due to the high resistance of the semiconductor layer, it is determined based on the presence or absence of peaks (385 to 400 nm) derived from an acceptor element by photoluminescence spectroscopy (PL), or the method that the content of an acceptor element (Mg, etc.) and the content of a donor element (Si, etc.) obtained by secondary ion mass spectrometry (SIMS) are compared, and in the case where the content of the acceptor element is more than the content of the donor element, the semiconductor layer is determined as a p-type semiconductor, and in the case where the content of the donor element is more than the content of the acceptor element the semiconductor layer is determined as an n-type semiconductor. In any of these types, the semiconductor layer may contain both of an acceptor element and a donor element with a difference in their contents of one-order of magnitude or more (10 times or more) in the molar ratio of the elements.

The semiconductor layer can be, for example, a component for forming an ultraviolet radiating member. The ultraviolet radiating member may be a member capable of radiating ultraviolet rays, and may have an ultraviolet emitting layer in addition to the semiconductor layer. In one embodiment the semiconductor layer is disposed between the ultraviolet emitting layer and the buffer layer. In the step of forming the buffer layer, or in the step of forming an electrode layer on the buffer layer, an ultraviolet emitting layer may be stacked on the semiconductor layer, or an ultraviolet emitting layer may not be stacked on the semiconductor layer.

[Buffer layer]

The buffer layer contributes to increasing the ultraviolet transmittance and conductivity of the electrode layer formed on the buffer layer.

In this aspect, the buffer layer contains one or more metals selected from the group consisting of Ga, Al, In, and Zn, and oxygen as constituent elements. In one embodiment the buffer layer contains one or more metals selected from the group consisting of Ga and Zn, and oxygen as constituent elements. In one embodiment, the buffer layer contains Ga and Zn, and oxygen as constituent elements.

The buffer layer preferably contains oxide of zinc, and more preferably contains oxide of gallium and oxide of zinc. Incidentally, the oxide of gallium and the oxide of zinc may or may not include a solid-solution of gallium and zinc $(GaZnO_x)$.

The molar ratio (atomic ratio) of Ga to the sum of Ga and Zn $[Ga/(Ga+Zn)]$ in the buffer layer may be, for example, 0.000 (Ga is not contained), 0.000 or more, 0.001 or more, 0.005 or more, 0.010 or more, or 0.015 or more, and may be 0.2 or less, 0.1 or less, or 0.05 or less.

The buffer layer may further contain a trivalent or tetravalent element Z other than Ga, Al, In, and Zn. When the buffer layer contains such an element Z, the molar ratio of the element Z to all metal elements [element Z/all metal elements] in the buffer layer may be, for example, 0.0001 or more, or 0.001 or more, and may be 0.20 or less, or 0.10 or less. Examples of the element Z include B, Tl, C, Si, Ge, Sn, and Pb.

The composition of the buffer layer can be controlled, for example, by adjusting the composition of the sputtering target when formed by sputtering. It can also be controlled by co-sputtering with a sintered target of the oxide of gallium $(GaO_x)$ and a sintered target of oxide of zinc $(ZnO_x)$, and an optional sintered target containing an element Z, while controlling the respective deposition rates. As for other film forming methods, the composition of the buffer layer can be controlled by adjusting the composition of raw materials such as vapor deposition sources.

Also, a buffer layer can be obtained by reactive sputtering using a metal target such as Ga, In, Al, or Zn to introduce oxygen thereto.

In the case of forming a buffer layer by sputtering or vapor deposition, the composition of the buffer layer substantially coincides with the composition of the sputtering target and the composition of the vapor deposition sources. However, an element easily bonded with oxygen may be lowered in the deposition rate on the substrate. In such a case, it is possible to appropriately select the composition of the sintered targets in consideration of the deviation of the composition ratio due to the difference in the deposition rates.

The molar ratio of each element in the buffer layer can be measured, for example, by secondary-ion mass spectrometry. The molar ratio of each element of the electrode layer as described later is also measured in the same manner.

In one embodiment, the buffer layer consists essentially of one or more metals selected from the group consisting of Ga, Al, In, and Zn, and oxygen or consists essentially of one or more metals selected from the group consisting of Ga, Al, In, and Zn, oxygen and an element Z.

In one embodiment 90% by mass or more, 95% by mass or more, or 99% by mass or more of the buffer layer is occupied by one or more metals selected from the group consisting of Ga, Al, In, and Zn, and oxygen, or is occupied by one or more metals selected from the group consisting of Ga, Al, In, and Zn, and oxygen and an element Z.

In one embodiment the buffer layer consists of one or more metals selected from the group consisting of Ga, Al, In, and Zn, and oxygen, or consists of one or more metals selected from the group consisting of Ga, Al, In, and Zn, and oxygen and element Z. In this case, the buffer layer may contain an unavoidable impurity.

The thickness of the buffer layer is not particularly limited, and may be, for example, 1 nm or more, 2 nm or more, or 3 nm or more, and may be 100 nm or less, 50 nm or less, 30 nm or less, or 20 nm or less. Cross-sectional shapes in the thickness direction and the like can be confirmed by, for example, a scanning electron microscope (SEM) or a transmission electron microscope (TEM). The smaller the thickness of the buffer layer becomes, the more the ultraviolet transmittance increases. When the thickness of the buffer layer is 1 nm or more, the effect of the crystal orientation of the electrode film is exhibited more favorably, and when the thickness of the buffer layer is 2.5 nm or more, the conductivity increases more favorably.

[Electrode layer]

The electrode layer is formed on the buffer layer. In one embodiment, the electrode layer is formed in direct contact with the buffer layer. The orientation of the electrode layer is controlled by the buffer layer, and the ultraviolet transmittance and conductivity of the electrode layer are increased.

The electrode layer contains oxide of magnesium and oxide of zinc. Note that the oxide of magnesium and the oxide of zinc may or may not contain a solid solution of magnesium and zinc ($MgZnO_x$).

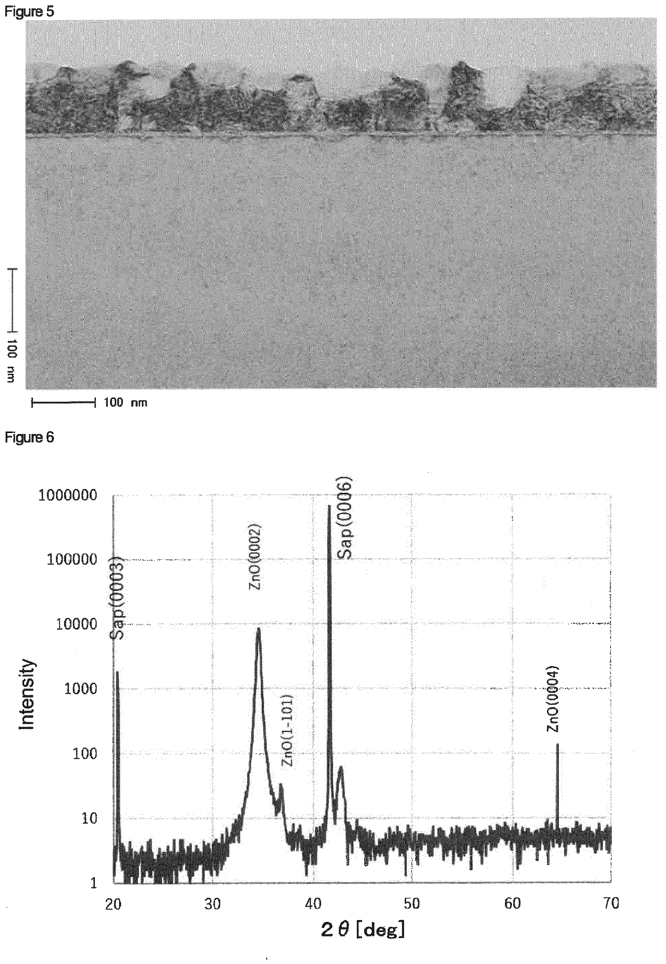

The electrode layer of this embodiment contains a region mainly composed of an oxide of zinc (ZnO or the like) having conductivity but not ultraviolet transmittance, and a region mainly composed of an oxide of magnesium (MgO or the like) having no conductivity but ultraviolet transmittance in a dispersed state to each other, as exemplified in a TEM image of the electrode layer cross section in Figure 5. Then, it is presumed that the region mainly composed of an oxide of zinc plays a role of exhibiting the conductivity, and the region mainly composed of an oxide of magnesium plays a role of exhibiting the ultraviolet transmittance. As a result, the electrode layer has both the conductivity and the ultraviolet transmittance. It is considered that this conduction phenomenon can be explained by the percolation conduction model.

In order to more suitably exhibit the conductivity and the ultraviolet transmittance, the molar ratio (atomic ratio) of Mg to the sum of Mg and Zn [Mg/(Mg+Zn)] in the electrode layer is preferably set to 0.25 or more and 0.75 or less.

Such molar ratio [Mg/(Mg+Zn)] may be, for example, 0.25 or more, 0.30 or more, 0.31 or more, 0.33 or more, 0.35 or more, 0.37 or more, 0.40 or more, 0.43 or more, 0.45 or more, 0.47 or more, or 0.5 or more, and may be 0.75 or less or 0.70 or less.

In one embodiment, such molar ratio [Mg/(Mg+Zn)] is 0.30 or more and 0.75 or less, 0.33 or more and 0.75 or less, or 0.40 or more and 0.75 or less, and is more preferably 0.50 or more and 0.75 or less.

In this embodiment, it is preferable that the electrode layer further contain a trivalent or tetravalent element X other than Mg and Zn. The molar ratio of the element X to all metal elements [element X/all metal element] is preferably 0.0001 or more and 0.20 or less, and more preferably 0.001 or more and 0.10 or less. When the electrode layer contains an element X, the element X is doped into the oxide of zinc, and the conductivity may be further increased in some cases.

Examples of the element X include B, Al, Ga, In, Tl, C, Si, Ge, Sn, and Pb. B, Al, or Ga is preferable.

The composition of the electrode layer can be controlled, for example, by adjusting the composition of the sputtering target when formed by sputtering. It can also be controlled by co-sputtering with a sintered target of the oxide of magnesium ($MgO_x$) and a sintered target of oxide of zinc ($ZnO_x$), and an optional sintered target containing an element X, while controlling the respective deposition rates. As for other film forming methods, the composition of the electrode layer can be controlled by adjusting the composition of raw materials such as vapor deposition sources. A sintered target containing an oxide of magnesium and an oxide of zinc can be produced, for example, by reference to WO2012014688.

In the case of forming the electrode layer by sputtering or vapor deposition, the composition of the electrode layer substantially coincides with the composition of the sputtering target and the composition of the deposition source.

In one embodiment, the electrode layer consists essentially of an oxide of magnesium and an oxide of zinc, or consists essentially of an oxide of magnesium, an oxide of zinc, and an oxide of the element X.

In one embodiment, 90% by mass or more, 95% by mass or more, or 99% by mass or more of the electrode layer is occupied by an oxide of magnesium and an oxide of zinc, or occupied by an oxide of magnesium, an oxide of zinc, and an oxide of the element X

In one embodiment, the electrode layer consists of an oxide of magnesium and an oxide of zinc, or consists of an oxide of magnesium, an oxide of zinc, and an oxide of the element X. In this case, the electrode layer may contain an unavoidable impurity.

The electrode layer may be one undergone heat treatment. By such heat-treatment, a suitable morphology which exhibits conductivity and ultraviolet transmittance can be formed in the electrode layer. It is preferable that the heat treatment is applied to an electrode layer formed on the buffer layer.

The heat treatment temperature of the electrode layer may be, for example, 750°C or higher, 800°C or higher, or 900°C or higher, and may be 1200°C or lower.

The heat treatment time of the electrode layer may be appropriately adjusted depending on the treatment temperature, the thickness of the electrode layer, and the like. Usually, the heat treatment time is 30 seconds to 1 hour.

The heat treatment is preferably carried out in an inert atmosphere such as a nitrogen atmosphere or a reducing atmosphere such as a hydrogen atmosphere.

The conductivity of the stacked unit composed of the electrode layer and the buffer layer (the partial structure constituted by the electrode layer and the buffer layer in the stacked body) may be, for example, 0.01 S/cm or higher, 0.05 S/cm or higher, 0.1 S/cm or higher, 0.2 S/cm or higher, 0.3 S/cm or higher, 0.4 S/cm or higher, or 0.5 S/cm or higher. The upper limit thereof is not particularly limited and may be, for example, 10000 S/cm or lower. Here, the conductivity is a value measured at 25°C. The conductivity of the stacked unit composed of an electrode layer and a buffer layer is measured by the method described in Example.

The conductivity of the stacked unit composed of an electrode layer and a buffer layer is preferably 0.5 S/cm or higher. By making the conductivity to be above-mentioned range, when the electrode layer is used, for example, as an electrode of a semiconductor device, it is possible to increase the conductivity and current injecting efficiency. The electrode layer can be heat-treated such that the conductivity of the stacked unit composed of an electrode layer and a buffer layer becomes an intended value, for example, 0.5 S/cm or higher.

By providing a buffer layer, such high conductivity as described above can be suitably achieved. Such a high conductivity as described above can be more suitably achieved by providing a buffer layer and by subjecting the electrode layer to heat treatment In one embodiment, when the electrode layer on which the buffer layer is stacked and the electrode layer on which the buffer layer is not stacked are heat-treated at the same temperature, the electrode layer on which the buffer layer is stacked exhibits higher ultraviolet transmittance and conductivity.

By the X-ray diffraction measurement of the electrode layer, a diffraction peak is observed at $2\theta = 34.8 \pm 0.5$ deg. This diffraction peak derives from the ZnO(0002) plane. The half width of the diffraction peak, i.e. the half width of the diffraction intensity of the ZnO(0002) plane is 0.43 deg or smaller. As a result, the ultraviolet transmittance and conductivity of the electrode layer are further increased. Such a half width may be observed at, for example, 0.40 deg or smaller, 0.38 deg or smaller, 0.36 deg or smaller, 0.34 deg or smaller, 0.33 deg or smaller, 0.32 deg or smaller, or 0.31 deg or smaller. The lower limit thereof is not particularly limited and may be, for example, 0.001 deg or larger.

The half width of the diffraction intensity of the ZnO(0002) plane is measured by the method described in Example.

The light transmittance of the stacked unit composed of an electrode layer and a buffer layer at a wavelength of 260 nm is preferably 4% or more, more preferably 10% or more, and still more preferably 20% or more. The upper limit thereof is not particularly limited, and is, for example, 80% or less. In this embodiment, the stacked unit can sufficiently transmit even light having a wavelength of 260 nm, which is a deep ultraviolet ray. The electrode (electrode layer) according to this embodiment having high light transmittance in the deep ultraviolet region (region of a wavelength of 260 nm or less) (or has transparency in the deep ultraviolet region) and good conductivity can be suitably used in a deep ultraviolet light-emitting semiconductor device or the like as an alternative technology for a mercury lamp. The light transmittance is a value measured by the method described in Example.

The thickness of the electrode layer can be appropriately adjusted so as to obtain a desired light transmittance and conductivity. For example, it is preferably in the range of 1 nm to 10 $\mu$m, and further preferably in the range of 10 nm or more and 1 $\mu$m or less. Cross-sectional shapes in the thickness direction and the like can be confirmed by, for example, a scanning electron microscope (SEM) or a transmission electron microscope (TEM).

The electrode layer may be an amorphous layer or a polycrystalline layer, as long as the region through which electrons flow is electrically connected. Further, the electrode layer may be a layer in which an amorphous component and a crystalline component are mixed. The crystallinity of the electrode layer can be determined from the lattice image of TEM.

In one embodiment, the buffer layer contributes to orienting the crystals contained in the electrode layer formed on the buffer layer so as to increase the ultraviolet transmittance and conductivity of the electrode layer. In one embodiment, the buffer layer contributes to orienting the crystals contained in the electrode layer in the thickness direction of the electrode layer (in a direction perpendicular to the surface on which the electrode layer is formed).

In one embodiment the electrode layer contains ZnO with a hexagonal c-axis oriented in the thickness direction of the electrode layer.

In one embodiment the electrode layer contains ZnO with a hexagonal c-axis oriented in the thickness direction of the electrode layer, and Mg is solid-dissolved in the ZnO.

The degree of c-axis orientation of the electrode layer may be, for example, 40% or more, 50% or more, 60% or more, 70% or more, 80% or more, 90% or more, or 95% or more, and may be less than 100%, 99.9% or less, or 99.8% or less. The degree of c-axis orientation of the electrode layer is preferably 40% or more, 40% or more and 99.9% or less, and still more preferably 50% or more and 99.8% or less. By making the degree to be in the above-mentioned range, the conductivity of the electrode layer is further increased.

The degree of c-axis orientation of the electrode layer is measured by the method described in Example.

[Wiring layer]

In one embodiment the stacked body further has a wiring layer. The wiring layer can be provided so as to be in direct contact with a portion of the electrode layer. The wire layer assists electrical conduction of the electrode layer and is useful in semiconductor devices that require high currents.

In this embodiment since ultraviolet rays are taken out from the apparatus through the electrode layer, it is preferable that the wiring layer be formed so as not to block ultraviolet rays as much as possible. Specifically, the wiring layer may be formed in a linear shape (stripe shape) near the end of the electrode layer, or may be formed on the electrode layer in a lattice shape having a large degree of opening. In any of the shapes, it is preferable to reduce the width of the wiring layer as much as possible.

The wiring layer is preferably formed on the surface of the electrode layer opposite to the surface in direct contact with the semiconductor layer of the electrode layer. Further, the wiring layer is preferably formed of a material having higher conductivity than that of the electrode layer. Examples thereof include metals containing one or more selected from Ni, Pd, Pt, Rh, Zn, In, Sn, Ag, Au, Mo, Ti, Cu, and Al (when two or more are selected, the metal may be an alloy), oxides such as ITO, $SnO_2$, ZnO, $In_2O_3$, $Ga_2O_3$, $RhO_2$, NiO, CoO, PdO, PtO, $CuAlO_2$, and $CuGaO_2$, nitrides such as TiN, TaN, and SiNx, and poly-Si (polysilicon), and the like.

When visible light is taken out along with ultraviolet rays through the electrode layer, it is preferable that the wiring layer be a transparent conductive oxide or a transparent conductive nitride having light transmittance.

The wiring layer may be a single layer or a stacked layer of two or monolayers. For example, a layer containing Ni may be formed in direct contact with the electrode layer, and an Au layer may be stacked on the Ni layer in order to prevent oxidation. Further, each layer constituting the wiring layer may contain at least one selected from the group consisting of metals, oxides, and nitrides described above.

The thickness of the wiring layer can be appropriately adjusted so as to obtain desired electrical characteristics. For example, a range of 10 nm to 10 $\mu$m is preferred.

[Others]

The constituent members of each of the embodiments described above can be produced by applying a known film formation technology, and may be produced by using a known technology.

The film formation technology is not particularly limited and examples thereof may include, for example, resistive-line heating deposition, electron beam (EB) deposition, sputtering, atomic layer deposition (ALD) film formation, thermochemical vapor deposition (thermal CVD), parallel plate plasma CVD, magnetic field microwave plasma CVD, inductively coupled plasma CVD, spin coating, ion plating, and the like.

In the case of film formation by sputtering, the reactive sputtering using a metal target under an oxygen-containing atmosphere can also be suitably used. By using the reactive sputtering using a metal target the film formation rate is increased as compared with the sputtering using an insulator target

During the formation of the buffer layer and the electrode layer, from the viewpoint of reducing thermal damage to the other layers such as a semiconductor layer, it is preferable to use sputtering using at least one selected from $O_2$, Ar, and $N_2$ as the sputtering gases, or ion plating. The wiring layer may be formed, for example, by sputtering or vapor deposition described above.

In one embodiment, a method of producing a stacked body has a step of forming an electrode layer on a buffer layer. In one embodiment, a method of producing a stacked body has a step of forming a buffer layer on a support, and a step of forming an electrode layer on the buffer layer.

In one embodiment a method of producing a stacked body has a step of forming a buffer layer on a support including a semiconductor layer, and then a step of forming an electrode layer on the buffer layer.

In another embodiment a method of producing a stacked body has a step of forming a buffer layer on a support including an ultraviolet transmitting member, and then a step of forming an electrode layer on the buffer layer. Further, the method may has a step of forming a semiconductor layer on the electrode layer. According to this embodiment, since it is not necessary that the semiconductor layer is stacked on the electrode layer at the time of heat-treating the electrode layer, the semiconductor layer later to be stacked on the electrode layer can be suitably protected from the influence of the heat treatment.

[Application]

The application of the stacked body described above is not particularly limited, for example, the stacked body can be used as a component of a semiconductor device.

A semiconductor device according to an aspect of the invention equips with a stacked body according to an aspect of the invention. As a result the semiconductor device having excellent luminous efficiency in the ultraviolet region is obtained. In the semiconductor device, the electrode layer can exhibit excellent current-voltage characteristics and can also exhibit excellent ultraviolet transmittance.

In one embodiment ultraviolet rays which the semiconductor device emits is transmitted through the electrode layer. In one embodiment ultraviolet rays the semiconductor device emits are transmitted through the stacked body according to an aspect of the invention, preferably through the buffer layer and the electrode layer in this order. The ultraviolet rays transmitted through the electrode layer may be radiated to the outside of the semiconductor device. In one embodiment, the electrode layer can be used for application of a voltage in order to let the semiconductor device to emit ultraviolet rays.

The semiconductor device is not particularly limited, and examples thereof include, for example, short wavelength light-emitting diodes, short wavelength light-emitting laser diodes, and the like using gallium nitride semiconductors, that emit visible-light and/or ultraviolet rays. In one embodiment, the semiconductor device is a deep ultraviolet light-emitting semiconductor device that emits ultraviolet rays in a deep ultraviolet region (a region of wavelength of 260 nm or less).

Hereinafter, as a semiconductor device having the stacked body, a specific example of a light-emitting diode will be described with reference to Figures. Note that the semiconductor device is not limited to the following examples.

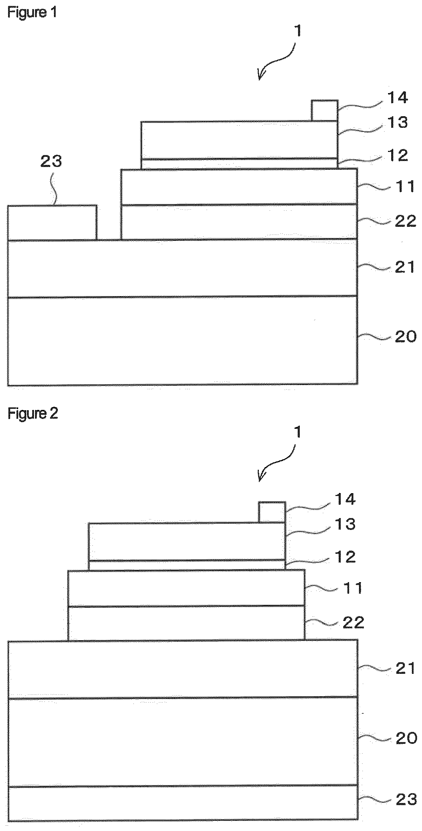

Figure 1 is a schematic configuration diagram of a light-emitting diode according to the first embodiment.

In this embodiment the light-emitting diode 1 has a substrate 20, an n-type GaN-based semiconductor layer 21, an ultraviolet emitting layer 22, an electrode layer (cathode) 23, a semiconductor layer (p-type GaN-based semiconductor layer) 11, a buffer layer 12, an electrode layer 13, and a wiring layer 14.

Specifically, an n-type GaN-based semiconductor layer 21 is stacked on a substrate 20. An electrode layer 23 (cathode) is provided on a portion in the vicinity of an edge of the semiconductor layer 21, and an ultraviolet emitting layer 22 is provided in the other portion (a portion other than the portion where the electrode layer 23 is provided and the periphery thereof). On the ultraviolet emitting layer 22, a semiconductor layer (p-type GaN-based semiconductor layer) 11, a buffer layer 12, and an electrode layer 13 are provided. In the vicinity of the edge portion of the upper surface of the electrode layer 13, a wiring layer 14 is provided.

Figure 2 is a schematic configuration diagram of a light-emitting diode according to the second embodiment. In Figure 2, the configurations indicated by the same reference numbers as in Figure 1 indicate the same ones.

In this embodiment a light-emitting diode 1 has a structure in which an electrode layer 23 (cathode), a substrate 20, an n-type GaN-based semiconductor layer 21, an ultraviolet emitting layer 22, a semiconductor layer (p-type GaN-based semiconductor layer) 11, a buffer layer 12, and an electrode layer 13 are stacked in this order. For other configurations, the explanation given for the first embodiment is incorporated.

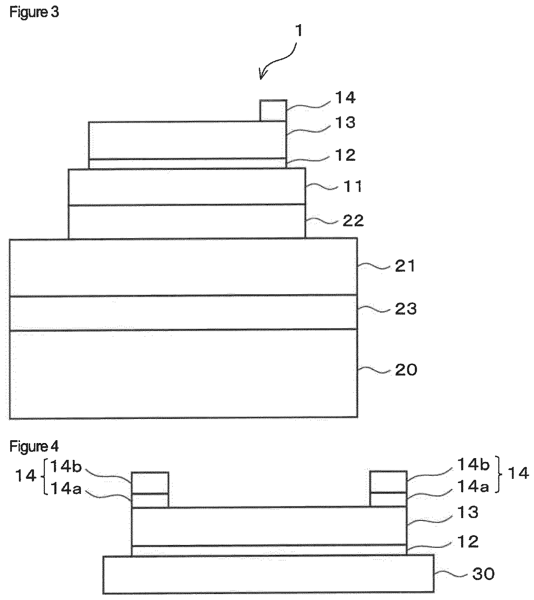

Figure 3 is a schematic configuration diagram of a light-emitting diode according to the third embodiment. In Figure 3, configurations indicated by the same reference numbers as in Figure 1 shows the same ones.

In this embodiment a light-emitting diode 1 has a structure in which a substrate 20, an electrode layer 23 (cathode), an n-type GaN-based semiconductor layer 21, an ultraviolet emitting layer 22, a semiconductor layer (p-type GaN-based semiconductor layer) 11, a buffer layer 12, and an electrode layer 13 are stacked in this order. For other configurations, the explanation given for the first embodiment is incorporated.

In the light-emitting diodes according to the first to third embodiments, when a voltage is applied between the electrode layer 13 and the electrode 23 through the wiring layer 14, holes are injected into the semiconductor layer 11, and electrons are injected into the n-type GaN-based semiconductor layer 21. The injected holes and electrons are recombined in the ultraviolet emitting layer 22 to emit light

In the light-emitting diodes according to the first to third embodiments, a buffer layer may be provided in direct contact with the electrode layer 23. By providing the buffer layer, the ultraviolet transmittance and conductivity of the electrode layer 23 can be increased in the same manner as in the electrode layer 13.

In the light-emitting diodes according to the first to third embodiments, the wiring layer 14 may be omitted. In this case, a voltage is applied between the electrode layer 13 and the electrode layer 23 without using a wiring layer.
The constituent members of each of the embodiments described above can be produced by applying a known film formation technology, and may be produced by using a known technology.

Examples

Example 1

A schematic cross-sectional view of the evaluation sample fabricated in each of Examples and Comparative Examples (provided that in the evaluation sample of Comparative Example 3, formation of a buffer layer 12 described later was omitted) are shown in Figure 4.
An evaluation sample shown in Figure 4 has a structure in which a support 30, a buffer layer 12, and an electrode layer 13 are stacked in this order.
A pair of wiring layers 14 are provided on the electrode layer 13.
A method of fabrication will be described below.

(1) Formation of buffer layer 12

A sapphire substrate (thickness: 0.5 mm) of a support 30 was placed in an ultrasonic cleaner and washed with trichloroethylene for 5 minutes, with acetone for 5 minutes, with methanol for 5 minutes, and finally with distilled water for 5 minutes.
Thereafter, the support 30 was set in a sputtering apparatus (manufactured by ULVAC, Inc.: ACS-4000), a buffer layer 12 having a thickness of 20 nm was formed on the support 30 by sputtering a sputtering target of oxide of gallium-zinc oxide having a molar ratio [Ga/(Ga+Zn)] of 0.02 (2%) (manufactured by Furuuchi Chemical Corporation) at 25°C and using Ar as the sputtering gas.

(2) Formation of electrode layer 13

Next, an electrode layer 13 having a thickness of 100 nm was formed on the buffer layer 12 by sputtering a sputtering target of oxide of magnesium-oxide of zinc having a molar ratio [Mg/(Mg+Zn)] of 0.33 (manufactured by Furuuchi Chemical Corporation; hereinafter, sometimes denoted as MZO (1:2)) at 25°C and using Ar as the sputtering gas.

(3) Heat treatment

The electrode layer 13 formed on the buffer layer 12 was subjected to heat treatment (activation annealing) at 950°C for 5 minutes in a nitrogen atmosphere.

(4) Evaluation of crystal state and crystal orientation

[Observation by TEM]

The vertical (thickness direction) cross-section of the electrode layer 13 after heat treatment was observed by a transmission electron microscopy ("H-9500," manufactured by Hitachi High-Technologies Corporation).
In Examples 1 and Examples 2 and 3 described later, a phase separation generated by annealing (heat treatment) was observed as a light and dark contrast. On the other hand, in Comparative Examples, a clear phase separation was not observed to the degree observed in Examples.

[X-ray diffraction (XRD) method]

The substrate undergone heat treatment was set in the XRD evaluation apparatus, and the crystallinity of the electrode layer (thin film) 13 was evaluated under the following conditions. XRD evaluation was performed under the following conditions.

Apparatus: Ultima-III, manufactured by Rigaku Corporation
X-ray: Cu-Ka line (wavelength: 1.5406 Å, monochromatized by graphite monochromator)
Output :40 kV-40 mA
$2\theta$-$\theta$ reflection method, continuous scan (1.0 deg/min), measurement range 20 deg to 70 deg

Sampling interval: 0.02 deg
Slit DS, SS: 2/3 deg, RS: 0.6 mm

By the above XRD evaluation, the degree of c-axis orientation of the electrode layer was determined using the following equation:

$$\text{c-axis orientation degree (\%)} = \{(P-P_0)/(1-P_0)\} \times 100$$

$P_0 = I_0(0002)/\Sigma I_0(hkil)$
$P = I_s(0002)/\Sigma I_s(hkil)$
where, $I_0(0002)$ represents the diffraction intensity of the (0002) plane in PDF (registered trademark; Powder Diffraction File) card number 01-075-0576 ($2\theta = 34.8\pm0.5$ deg) of ICDD (registered trademark; International Centre for Diffraction Data);
$I_s(0002)$ represents the diffraction intensity of the (0002) plane in the electrode layer (sample) (diffraction intensity of the peak appearing at $2\theta = 34.8\pm0.5$ deg);
$\Sigma I_0(hkil)$ represents the integral value of the diffraction intensity ($2\theta = 30$ deg to 60 deg) of the (hkil) plane in PDF card number 01-075-00576 of ICDD; and
$\Sigma I_s(hkil)$ represents the integral value of the diffractive intensity ($2\theta = 30$ deg to 60 deg) of the (hkil) plane in the electrode layer (sample).

Further, the half-width of the diffraction peak of ZnO(0002) plane (diffraction peak observed in $2\theta = 34.8\pm0.5$ deg) was determined as the full width at half maximum (FWHM).

(5) Hall-effect measurement

The substrate undergone the heat treatment was set in a specific resistance/Hall measuring system (manufactured by TOYO Corporation: ResiTest 8300), and the mobility $\mu$ and the carrier concentration n of the electrode layer 13 were measured at 23°C.

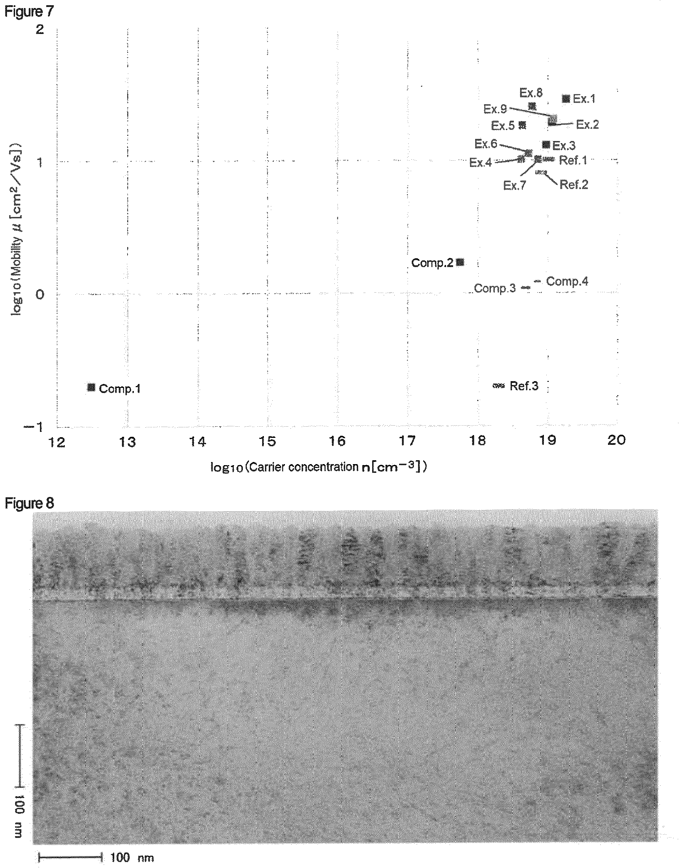

These results are shown in Table 1. TEM image is shown in Figure 5. X-ray diffraction pattern is shown in Figure 6. The relationship between the mobility $\mu$ and the carrier concentration n is shown in Figure 7. In Figure 7, "Ex." represents Example, "Comp." represents Comparative Example, and "Ref." represents Reference example, respectively.

(6) Formation of wiring layer 14

The substrate undergone the heat treatment was set together with an area mask in an EB deposition apparatus (manufactured by ULVAC, Inc.), and as shown in Figure 4, Ni layer 14a (thickness 20 nm) and Au layer 14b (thickness 200 nm) were deposited in order on the electrode layer 13 to form a pair of wiring layers 14 having a stacked structure.

(7) Measurements of specific resistivity, conductivity, and light transmittance

For the evaluation sample in which the wiring layer 14 is formed, the specific resistance and conductivity of the stacked unit composed of an electrode layer 13 and a buffer layer 12 were measured at 25°C by using a specific resistivity/Hall measuring system (TOYO Corporation: ResiTest 8300).

Further, a light transmittance of a wavelength of 260 nm of a stacked unit composed of an electrode layer 13 and a buffer layer 12 was evaluated at 25°C by using a spectrophotometer (manufactured by Shimadzu Corporation: UV-2600). (Light transmittances of respective wavelengths of 280 nm and 310 nm were also evaluated in Examples 5 to 9, Comparative Example 4, and Reference Examples 1 to 3 described later). Here, the light transmittance of the stacked unit is a value obtained by removing the measured light transmittance for only the supporting substrate (here, sapphire substrate) as the background value.

These results are shown in Table 1.

Example 2

An evaluation sample was fabricated and evaluated in the same manner as in Example 1, except that the heat treatment temperature was 1060°C. The results are shown in Table 1 and Figure 7.

Example 3

An evaluation sample was fabricated and evaluated in the same manner as in Example 1, except that the heat treatment temperature was 1150°C. The results are shown in Table 1 and Figure 7.

Comparative Example 1

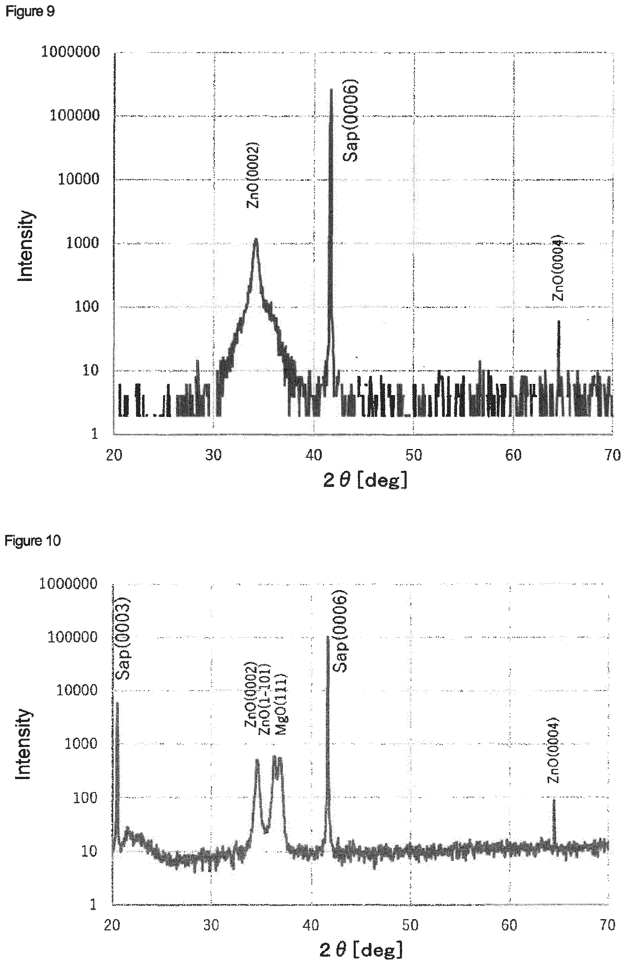

An evaluation sample was fabricated and evaluated in the same manner as in Example 1, except that the heat treatment was omitted. The results are shown in Table 1 and Figure 7. TEM image is shown in Figure 8. X-ray diffraction pattern is shown in Figure 9.

Comparative Example 2

An evaluation sample was fabricated and evaluated in the same manner as in Example 1, except that the heat treatment temperature was 600°C. The results are shown in Table 1 and Figure 7.

Comparative Example 3

An evaluation sample was fabricated and evaluated in the same manner as in Example 1, except that formation of the buffer layer was omitted and the electrode layer was directly formed on a support (sapphire substrate). The results are shown in Table 1 and Figure 7. X-ray diffraction pattern is shown in Figure 10.

Table 1

|  | Ex. 1 | Ex. 2 | Ex. 3 | Comp. Ex. 1 | Comp. Ex. 2 | Comp. Ex. 3 |
|---|---|---|---|---|---|---|
| Thickness of buffer layer [nm] | 20 | 20 | 20 | 20 | 20 | 0 (None) |
| Thickness of electrode layer [nm] | 100 | 100 | 100 | 100 | 100 | 100 |
| Heat treatment temperature [°C] | 950 | 1060 | 1150 | No heat treatment (RT) | 600 | 950 |
| Sputtering target | MZO(1:2) | MZO(1:2) | MZO(1:2) | MZO(1:2) | MZO(1:2) | MZO(1:2) |
| Degree of c-axis orientation [%] | 99.7 | 99.8 | 95.6 | 100 | 100 | 35.5 |
| Half-width of (0002) plane [°] | 0.30 | 0.30 | 0.30 | 0.44 | 0.45 | 0.35 |
| Mobility $\mu$ [cm$^2$/Vs] | 28.2 | 19.1 | 12.8 | 0.198 | 1.68 | 1.07 |
| Carrier concentration n [cm$^{-3}$] | $1.79 \times 10^{19}$ | $1.12 \times 10^{19}$ | $9.39 \times 10^{18}$ | $3.10 \times 10^{12}$ | $5.49 \times 10^{17}$ | $4.85 \times 10^{18}$ |
| Specific resistance [$\Omega$cm] | 0.0317 | 0.0748 | 0.133 | $2.61 \times 10^7$ | 17.3 | 3.08 |
| Conductivity [S/cm] | 31.5 | 13.4 | 7.52 | $3.83 \times 10^{-8}$ | 0.0578 | 0.325 |
| Light transmittance [$\lambda$=260nm:%] | 26.7 | 33.1 | 46.6 | 9.4 | 13.0 | 22.8 |

Example 4

An evaluation sample was fabricated and evaluated in the same manner as in Example 1, except that the thickness of the buffer layer was set to 1.25 nm and the sputtering target used for the electrode layer was replaced with a sputtering target of oxide of magnesium-oxide of zinc having a molar ratio [Mg/(Mg+Zn)] of 0.5 (manufactured by Furuuchi Chemical Corporation, hereinafter, sometimes denoted as MZO(1:1)). The results are shown in Table 2 and Figure 7.

Examples 5 to 9

Evaluation samples were fabricated and evaluated in the same manner as in Example 4, except that the thickness of the buffer layer was changed to 2.5 nm, 5.0 nm, 10 nm, 20 nm, 50 nm, respectively. The results are shown in Table 2 and Figure 7.

Comparative Example 4

An evaluation sample was fabricated and evaluated in the same manner as in Example 4, except that formation of the buffer layer was omitted and the electrode layer was directly formed on a support (sapphire substrate). The results are shown in Table 2 and Figure 7.

Table 2

| | Ex. 4 | Ex. 5 | Ex. 6 | Ex. 7 | Ex. 8 | Ex. 9 | Comp. Ex. 4 |
|---|---|---|---|---|---|---|---|
| Thickness of buffer layer [nm] | 1.25 | 2.5 | 5.0 | 10 | 20 | 50 | (None) |
| Thickness of electrode layer [nm] | 100 | 100 | 100 | 100 | 100 | 100 | 100 |
| Heat treatment temperature [℃] | 950 | 950 | 950 | 950 | 950 | 950 | 950 |
| Sputtering target | MZO(1:1) | MZO(1:1) | MZO(1:1) | MZO(1:1) | MZO(1:1) | MZO(1:1) | MZO(1:1) |
| Degree of c-axis orientation [%] | >99 | >99 | >99 | >99 | >99 | >99 | 35 |
| Half-width of (0002) plane [°] | 0.35 | 0.30 | 0.35 | 0.35 | 0.30 | 0.35 | 0.35 |
| Mobility $\mu$ [cm$^2$/Vs] | 10 | 18 | 11 | 10 | 25 | 20 | 1.2 |
| Carrier concentration n [cm$^{-3}$] | $4.20 \times 10^{18}$ | $4.40 \times 10^{18}$ | $5.30 \times 10^{18}$ | $7.30 \times 10^{18}$ | $6.00 \times 10^{18}$ | $1.20 \times 10^{19}$ | $7.20 \times 10^{18}$ |
| Specific resistance [$\Omega$cm] | 0.381 | 0.202 | 0.274 | 0.219 | 0.107 | 0.0667 | 1.85 |
| Conductivity [S/cm] | 2.63 | 4.95 | 3.65 | 4.57 | 9.35 | 14.99 | 0.54 |
| Light transmittance [$\lambda$=260nm:%] | 23 | 26 | 28 | 23 | 23 | 10 | 35 |
| Light transmittance [$\lambda$=280nm:%] | 27 | 30 | 32 | 27 | 27 | 14 | 42 |
| Light transmittance [$\lambda$=310nm:%] | 32 | 30 | 34 | 25 | 25 | 16 | 38 |

Reference Examples 1 to 3

Evaluation samples were fabricated and evaluated in the same manner as in Example 1, except that formation of the buffer layer is omitted; in the formation of the electrode layer directly on the support (sapphire substrate), the respective molar ratios of Al to the total metal element [Al/all metal elements] were adjusted to the values shown in Table 3 by co-sputtering using a sputtering target of oxide of magnesium-oxide of zinc having a molar ratio [Mg/(Mg+Zn)] of 0.5 (manufactured by Furuuchi Chemical Corporation, "MZO (1:1)") and a sputtering target of oxide of magnesium-zinc-oxide of aluminum having a molar ratio [Mg:Zn:Al] of 49.5:49.5:1 (manufactured by Furuuchi Chemical Corporation, hereinafter, sometimes denoted as "AZO"), respectively; the thickness of the electrode layers were adjusted to the values shown in Table 3, respectively; and the heat treatment temperature was 850°C. The results are shown in Table 3 and Figure 7.

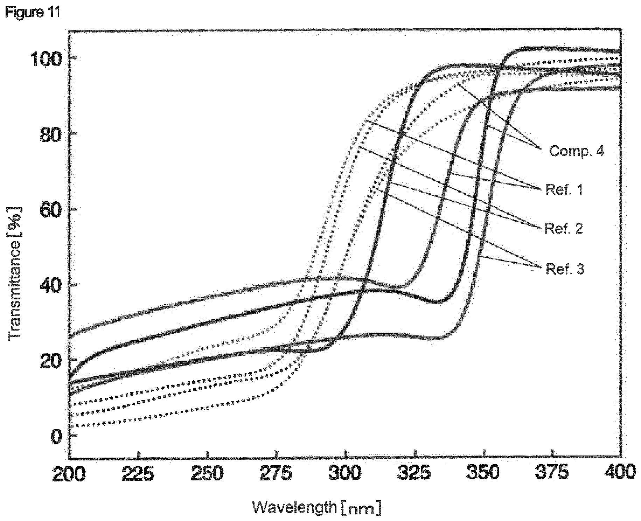

In addition, light transmission spectra at a wavelength of 200 to 400 nm measured for the electrode layers of Comparative Example 4 and Reference Examples 1 to 3 are shown in Figure 11. In Figure 11, the dotted line corresponds to the before heat treatment, the solid line corresponds to the after heat treatment, respectively.

Table 3

|  | Ref. Ex. 1 | Ref. Ex. 2 | Ref. Ex. 3 |
|---|---|---|---|
| Thickness of buffer layer [nm] | 0 (None) | 0 (None) | 0 (None) |
| Thickness of electrode layer [nm] | 62 | 125 | 125 |
| Heat treatment temperature [°C] | 850 | 850 | 850 |
| Sputtering target | MZO(1:1) +AZO | MZO(1:1) +AZO | MZO(1:1) +AZO |
| Molar ratio [Al/All metal elements] | 0.005 | 0.010 | 0.020 |
| Degree of c-axis orientation [%] | 50 | 50 | 50 |
| Half-width of (0002) plane [°] | 0.27 | 0.33 | 0.35 |
| Mobility $\mu$ [cm$^2$/Vs] | 10 | 8 | 0.2 |
| Carrier concentration n [cm$^{-3}$]. | $1.00 \times 10^{19}$ | $8.00 \times 10^{18}$ | $2.00 \times 10^{18}$ |
| Specific resistance [$\Omega$cm] | 0.16 | 0.25 | 4.00 |
| Conductivity [S/cm] | 6 | 45 | 0.25 |
| Light transmittance [$\lambda$=260nm:%] | 37 | 20 | 20 |
| Light transmittance [$\lambda$=280nm:%] | 40 | 20 | 22 |
| Light transmittance [$\lambda$=310nm:%] | 39 | 50 | 23 |

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the application claims Paris convention priority are incorporated herein by reference in its entirety.

**Claims**

1. A stacked body comprising a support, a buffer layer, and an electrode layer in this order, wherein

the buffer layer comprises one or more metals selected from the group consisting of Ga, Al, In, and Zn, and oxygen,
the electrode layer comprises an oxide of magnesium and an oxide of zinc, and
the electrode layer has a half width of a diffraction peak observed at 2θ = 34.8 ± 0.5 deg in X-ray diffraction measurement of 0.43 deg or smaller.

2. The stacked body according to claim 1, wherein a stacked unit comprising the electrode layer and the buffer layer has a conductivity of 0.5 S/cm or larger.

3. The stacked body according to claim 1 or 2, wherein a molar ratio of Mg to the sum of Mg and Zn [Mg/(Mg+Zn)] in the electrode layer is 0.25 or more 0.75 or less.

4. The stacked body according to any one of claims 1 to 3, wherein the stacked unit comprising the electrode layer and the buffer layer has a light transmittance at a wavelength of 260 nm of 4% or more.

5. The stacked body according to any one of claims 1 to 4, wherein the electrode layer has a degree of c-axis orientation of 40% or more.

6. The stacked body according to any one of claims 1 to 5, wherein the buffer layer comprises an oxide of zinc.

7. The stacked body according to any one of claims 1 to 6, wherein the buffer layer comprises an oxide of gallium and an oxide of zinc.

8. The stacked body according to any one of claims 1 to 7, wherein a molar ratio of Ga to the sum of Ga and Zn [Ga/(Ga+Zn)] in the buffer layer is 0.000 or more and 0.2 or less.

9. The stacked body according to any one of claims 1 to 8, wherein the support comprises an ultraviolet transmitting member.

10. The stacked body according to any one of claims 1 to 8, wherein the support comprises a semiconductor layer.

11. The stack body according to claim 10, wherein the semiconductor layer comprises a Group III-V nitride semiconductor.

12. The stacked body according to claim 10 or 11, wherein the semiconductor layer comprises AlN, GaN, InN, or a mixed crystal thereof.

13. A semiconductor device, comprising the stacked body according to any one of claims 1 to 12.

Figure 1

Figure 2

Figure 3

Figure 4

Figure 5

100 nm

├──────┤ 100 nm

Figure 6

Figure 7

Figure 8

100 nm

Figure 9

Figure 10

Figure 11

## INTERNATIONAL SEARCH REPORT

| | International application No. |
|---|---|
| | PCT/JP2020/041005 |

**A. CLASSIFICATION OF SUBJECT MATTER**
H01L 33/42(2010.01)i; B32B 9/00(2006.01)i
FI: H01L33/42; B32B9/00 A

According to International Patent Classification (IPC) or to both national classification and IPC

**B. FIELDS SEARCHED**

Minimum documentation searched (classification system followed by classification symbols)
H01L33/00-33/50; B32B1/00-43/00

Documentation searched other than minimum documentation to the extent that such documents are included in the fields searched
Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | CN 109599470 A (UNIVERSITY OF SCIENCE AND TECHNOLOGY OF CHINA) 09 April 2019 (2019-04-09) | 1-13 |
| A | WO 2016/132681 A1 (IDEMITSU KOSAN CO., LTD.) 25 August 2016 (2016-08-25) | 1-13 |
| A | JP 2013-120829 A (SHARP CORP.) 17 June 2013 (2013-06-17) | 1-13 |
| A | CN 101221830 A (ZHEJIANG UNIVERSITY) 16 July 2008 (2008-07-16) | 1-13 |
| A | JP 2006-128631 A (SAMSUNG ELECTRO-MECHANICS CO., LTD.) 18 May 2006 (2006-05-18) | 1-13 |
| A | WO 2005/103320 A1 (IDEMITSU KOSAN CO., LTD.) 03 November 2005 (2005-11-03) | 1-13 |

☐ Further documents are listed in the continuation of Box C.　　☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18 January 2021 (18.01.2021) | 02 February 2021 (02.02.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**
Information on patent family members

International application No.

PCT/JP2020/041005

| Patent Documents referred in the Report | Publication Date | Patent Family | Publication Date |
|---|---|---|---|
| CN 109599470 A | 09 Apr. 2019 | (Family: none) | |
| WO 2016/132681 A1 | 25 Aug. 2016 | (Family: none) | |
| JP 2013-120829 A | 17 Jun. 2013 | US 2013/0146916 A1 | |
| CN 101221830 A | 16 Jul. 2008 | (Family: none) | |
| JP 2006-128631 A | 18 May 2006 | US 2006/0091405 A1 KR 10-2006-0037938 A | |
| WO 2005/103320 A1 | 03 Nov. 2005 | CN 101124348 A KR 10-2007-0006854 A JP 2005-307269 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H8245220 A
- JP 2014129230 A
- WO 2012014688 A